# EUROPEAN PATENT APPLICATION

(11) **EP 0 762 136 A2**
(43) Date of publication of application: **12.03.1997**
(21) Application number: 96306285.6
(22) Date of filing: 30.08.1996
(51) Int. Cl.: G01R 31/08

(54) **Line fault location**

(30) Priority: 01.09.1995 US 523071
(71) Applicant: Crick, Robert G., Rancho Santa Fe, CA 92067 (US)
(72) Inventor: Crick, Robert G., Rancho Santa Fe, CA 92067 (US)
(74) Representative: Pratt, Richard Wilson

(57) **Abstract**

A device and method are provided for locating faults in a paired line. The fault locating device has a base unit and a terminator unit connectable to the conductors of a paired line containing the fault. The device also has a portable locator unit movable along the paired line between the base unit and the terminator unit. The locator unit contains a coil positioned at the paired line for coupling an induced signal thereon. The base unit and terminator unit each contain circuits for receiving the induced signal from the locator unit and measuring a selected characteristic of the induced signal. The base unit additionally has a circuit for creating a base carrier signal having the selected characteristic measured at the base unit and terminator unit encoded thereon. In operation, the base unit sends the encoded base carrier signal to the locator unit which decodes and continuously communicates values of the induced signal characteristic to the operator by means of an audible or visual indicator. The operator incrementally repositions the locator unit away from the base unit and toward the terminator unit as operation of the device proceeds. When the locator unit approaches the fault, the intensity and frequency of the indicator remains relatively stable except for some variation due to conductor twist and relative coil position. When the locator unit passes the fault, however, such that the fault is between the locator unit and the base unit, the intensity or frequency of the indicator abruptly drops, thereby establishing the precise location of the fault.

## Description

The present invention relates generally to fault location in a paired line, and more particularly, to a device and method for locating faults in a paired line by monitoring a current induced in the paired line.

The term "Paired Line" encompasses coaxial cable, shielded cable and cable having more than two conductors wherein any two conductors of the cable may be a paired line.

A paired line is a conventional means of carrying telecommunications transmissions. A paired line is typically two balanced conductors individually insulated and twisted together along their length in a spiral path. A plurality of paired lines are usually bundled together to form a paired cable containing up to one hundred or more paired lines, wherein each paired line of the paired cable is capable of independently carrying a telecommunications signal. A paired line is generally an effective telecommunications carrier, however, a fault can occasionally occur in a paired line limiting the effectiveness thereof. For example, a resistance fault can occur in a paired line when water invades the outer protective covering of a paired cable through an imperfection or other flaw therein. The resulting resistance fault is a resistive contact between the two conductors of a paired line contained within the paired cable. The resistance fault is also often accompanied by a resistance from one of the two conductors of the paired line to ground or to another conductor of the paired cable. Another type of fault can occur when there is a discontinuity or break in the shield of a paired cable. The fault allows an increased coupling of extraneous voltages into one or more enclosed paired lines from sources, such as power transmission cables, near the paired cable.

Such faults typically cause noise in the affected paired line that is extremely disruptive to the clarity of the telecommunications signal sent over the paired line. A fault in a paired line can also cause other problems such as circuit failure, arc-over and corrosion. Therefore, it is desirable to locate and repair faults in a paired line, particularly a paired line in a telecommunications cable.

Since telecommunications cables are not always readily accessible, often being buried below ground, noninvasive methods are preferred for locating faults in a paired line of a telecommunications cable. Tone location methods are conventional noninvasive means for locating a short fault in a paired line of a telecommunications cable. In accordance with one tone location method, an audible tone is placed across the shorted conductors of the paired line by means of a tone transmitter and the tone is followed to the fault by a pickup coil placed on the paired line that is connected to an amplifier and a headset worn by an operator. Because no tone current flows past the short fault, the tone is audible up to the fault and inaudible beyond the fault, allowing the operator to precisely pinpoint the short fault to within a few centimeters of its actual location.

This tone location method is ineffective, however, for locating most resistance faults in a paired line. One reason for such ineffectiveness is a phenomenon termed carry-by. Carry-by occurs at faults that exceed a threshold resistance typically above about 2000 ohms. Most resistance faults have a resistance in a range between about 5000 to about 50,000 ohms. When a resistance exceeding the threshold resistance for carry-by is encountered at the resistance fault in a paired line, the current of the audible tone produces a voltage across the conductors of the paired line past the fault. This voltage causes a corresponding tone current to flow into pair capacitance beyond the fault. Thus, a tone will be audible beyond the resistance fault defeating the present tone location method. The problem of carry-by is particularly acute when a high-frequency tone is present in the paired line, such as is typically employed in the present tone location method, because the magnitude of tone current flow past the fault is directly related to the frequency of the tone.

It is further noted that the tone transmitter drives less tone current through the paired line as the level of fault resistance increases. At relatively high levels of resistance, such as encountered in resistance faults, the level of tone current available to the coil can drop below the background noise level present on a paired cable. Consequently, the background noise masks the location of the fault.

To overcome the limitations of the above-recited tone location method caused by carry-by, another tone location method has been developed in the telephone industry, wherein the conductors of the paired line are welded together at the fault using a 600-volt, breakdown test set. Welding of the conductors reduces fault resistance to zero in the paired line, thereby allowing effective tone location of the resistance fault. This tone location method, however, can cause extensive cable and equipment damage, particularly to plastic insulated cable and electronic central offices due to the high breakdown voltages used. Accordingly, this tone location method for overcoming fault resistance is disfavored.

An alternate tone location method for locating resistance faults is disclosed in U.S. Patent 4,291,204, wherein a tone locating device temporarily reduces the fault resistance to a low value by establishing a transient arc at the fault. Passing the fault locating tone through the low-resistance arc at the fault reduces tone carry-by, but does not entirely eliminate it. In addition, the conductors and equipment are susceptible to damage caused by formation of the transient arc, albeit to a lesser degree than the damage potential of the previous tone location method.

Illustrative embodiments of the present invention described hereinafter seek to provide:
a device and method for effectively locating resistance faults and other types of faults in a paired line using a magnetic induced signal;
a device and method for effectively locating faults in a paired line using an induced signal, wherein the device and method do not require formation of an arc or a high-voltage weld at the fault;
a device and method for effectively locating resistance faults and other types of faults in a paired line using an induced signal, wherein the induced signal is inaudible to listeners on adjacent paired lines of a paired cable, yet detectable by the device, thereby minimizing interference with normal operation of the paired cable; and/or a device and method for effectively locating faults in a paired line using an induced signal, wherein the voltage and frequency of the induced signal are such that background noise is overcome while the impact of carry-by is minimized.

A further illustrative embodiment of the present invention described hereinafter seek to provide:
a device and method for effectively locating faults in a paired line using an induced signal, wherein the device is fully portable in the field for expeditiously tracking relatively long lengths of the paired line;
a device and method for effectively locating faults in a paired line using an induced signal that assists the operator in distinguishing changes in the induced signal due to depth variations from changes in the induced signal due to the presence of a fault; and/or
a device and method for effectively locating breaks in a shield of a paired cable.

Aspects of the invention are specified in the claims to which attention is invited.

An embodiment of the present invention provides a device and method for locating a fault in a paired line. The device and method are particularly applicable to the location of a resistance fault in a paired line of a telecommunications cable. The fault locating device comprises a base unit and a terminator unit each fixably connectable to an opposite end of the two conductors of a segment of a paired line believed to contain the fault. The fault locating device further comprises a portable locator unit movable along the conductors of the paired line segment between the base unit and the terminator unit.

The locator unit has internal circuitry and an associated coil that is positioned proximal to the conductors of the paired line segment, such that the coil is in magnetic communication but not electrical communication with the paired line. The internal circuitry of the locator unit includes a small, lightweight battery and a locator signal transmission circuit for creating a locator signal in the coil which couples a magnetic induced signal corresponding to the locator signal onto the conductors of the paired line segment. The circuitry of the locator unit also includes a carrier signal processing circuit for receiving an encoded carrier signal traveling along the conductors from the base unit, decoding the carrier signal and communicating the decoded information to an operator in the form of an indicator, such as an audible tone or a visual display.

The base unit has circuitry including an induced signal receiver circuit for receiving the induced signal from the locator unit via the conductors of the paired line segment and a base carrier signal transmission circuit for creating and sending a base carrier signal having synchronization markers and values of a selected induced signal characteristic measured at the base unit and terminator unit encoded thereon. The base unit also has a terminator carrier signal receiver circuit for receiving a terminator carrier signal having values of the selected induced signal characteristic measured at the terminator unit encoded thereon. The base unit further includes noise nulling and synchronization circuitry for minimizing the effect of noise and carry-over received over the induced signal receiver circuit.

The terminator unit, like the base unit, has an induced signal receiver circuit for receiving the induced signal from the locator unit via the conductors of the paired line segment. The terminator unit also has a terminator carrier signal transmission circuit for creating and sending the terminator carrier signal. In addition, the terminator unit has a base carrier signal receiver circuit for receiving the base carrier signal.

Operation of the fault locating device is performed by positioning the locator unit along the paired line segment near the base unit, wherein the fault is believed to be located between the locator unit and the terminator unit. The locator unit is activated, creating the magnetic induced signal on the conductors of the paired line segment. The magnetic induced signal travels along the conductors of the paired line segment and is received by the base unit and terminator unit.

In response to receipt of the induced signal, the base unit measures values of a selected induced signal characteristic at the base unit and encodes these values along with synchronization marks onto the base carrier signal. The base unit sends the resulting encoded base carrier signal to the locator unit. The terminator unit similarly measures values of the selected induced signal characteristic at the terminator and encodes these values onto the terminator carrier signal. The terminator sends the encoded terminator carrier signal to the base unit which additionally encodes the values from the terminator carrier signal onto the base carrier signal. The locator unit receives the base carrier signal, decodes the base carrier signal and continuously communicates the decoded values of the induced signal characteristic measured at the base unit and terminator unit to the operator by means of an indicator. The operator incrementally repositions the locator unit away from the base unit and toward the terminator unit along the path of the paired line segment as operation of the fault locating device proceeds.

As the locator unit approaches the fault, the intensity or frequency of the indicator remains substantially constant except for some variation due to twisting of the conductors or changes in the relative position of the coil and the paired line (e.g., depth changes). When the locator unit passes the fault, however, so that the fault is between the locator unit and the base unit, the intensity or frequency of the indicator abruptly drops, thereby establishing the precise location of the fault.

It is noted that the voltage and frequency of the magnetic induced signal are narrowly specified in accordance with the present invention to satisfy the performance requirements of the fault locating device. In particular, the voltage and frequency ranges of the induced signal are constrained at the upper end to satisfy the requirements that the induced signal on the paired line is inaudible to listeners and that the induced signal avoids excessive carry-by. The voltage and frequency ranges of the induced signal are constrained at the lower end to satisfy the requirements that sufficient voltage is coupled onto the paired line by the coil of the locator unit to provide an induced signal exceeding background noise and that the resulting induced signal is detectable by both the base and terminator units.

Accordingly, the voltage and frequency of the induced signal are balanced between an upper and lower limit to achieve a fully-portable fault locating device having an inaudible, yet detectable, magnetic induced signal, that exceeds the background noise on the paired line while avoiding the effects of excessive carry-by. Achievement of these performance requirements is facilitated by noise nulling circuitry that reduces the noise on the paired line and synchronization circuitry that mitigates the impact of carry-by.

For a better understanding of the present invention, reference will now be made, by way of example, to the accompanying drawings in which similar reference characters refer to similar parts and in which:-

Figure 1 is a conceptual view of an illustrative fault locating device according to the present invention operably positioned in relation to a paired line.

Figure 2 is a block diagram of the locator unit shown in the device of Figure 1 configured to locate resistance faults in a paired line.

Figure 3 is a block diagram of the base unit shown in the device of Figure 1.

Figure 4 is a block diagram of the terminator unit shown in the device of Figure 1.

Figures 5a, 5b, 5c depict conceptualized operation of a synchronous detector employed in the base unit of Figure 3.

Figure 6 is a block diagram of the locator unit shown in the device of Figure 1 configured to locate shield breaks in a shielded cable.

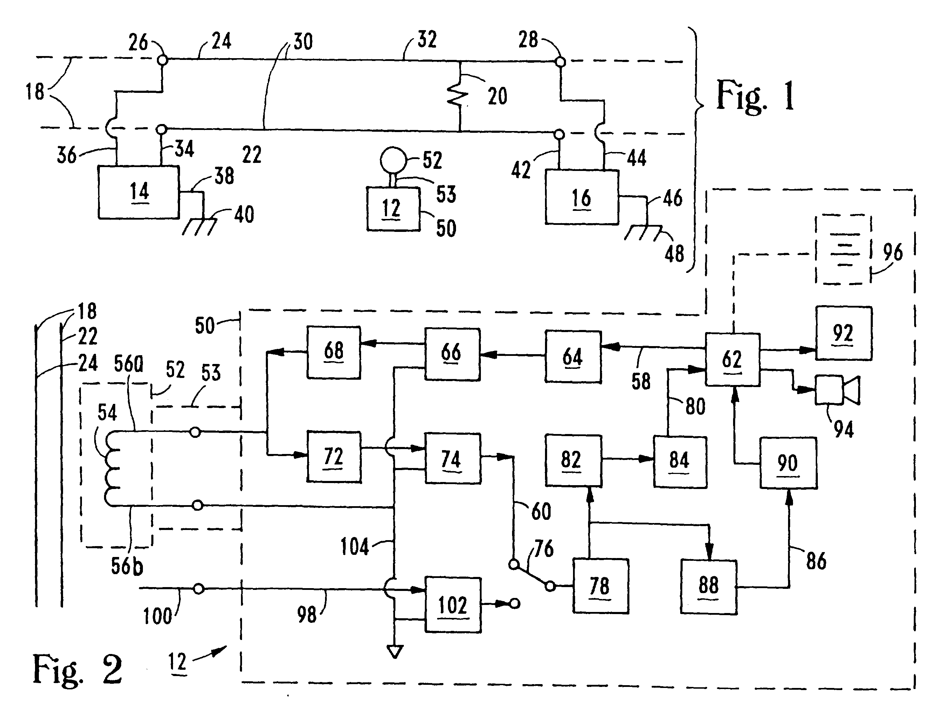

Referring initially to Figure 1, an illustrative fault locating device is shown and generally designated 10. The fault locating device 10 has three basic components comprising a locator unit 12, a base unit 14, and a terminator unit 16. The fault locating device 10 is operably positioned relative to a paired line 18, in which it is desired to locate a resistance fault 20, such that the base unit 14 engages a first conductor 22 and a second conductor 24 of the paired line 18 at a base point 26 on the paired line 18 and the terminator unit 16 engages the first and second conductors 22, 24 at a terminator point 28 on the paired line 18. The base point 26 and the terminator point 28 are positioned at opposite ends of a segment 30 of the paired line 18 that is selected to encompass the fault 20, at least to the best approximation of the operator. If it is subsequently determined that the selected paired line segment does not encompass the fault, the paired line segment is simply reselected until a paired line segment is selected encompassing the fault in accordance with a method described hereafter. In any case, for purposes of illustration, the paired line segment 30 of Figure 1 is shown to encompass the fault 20.

The illustrative fault locating device 10 has general utility to paired lines employed in a number of paired cable applications, including power transmission and communications paired cable applications. The fault locating device 10 has particular utility to paired lines employed in telecommunications paired cable applications, including accessible paired cables, such as aerial paired cables, and inaccessible paired cables, such as buried paired cables. As defined herein, a paired line is substantially any line having at least two continuous electrical conductors that, in the absence of a fault, are electrically insulated from one another. The two conductors can each be solid or braided wires, grounded or ungrounded and having parallel or spiral paths. Alternatively, one conductor can be a wire and the other conductor can be a conductive tubular shield enclosing the wire. The above-recited definition of a paired line encompasses coaxial cable, shielded cable, and cable having more than two conductors, wherein any two conductors of the cable may be deemed to define a paired line for purposes of the invention. For example, a paired line as defined herein includes a shielded cable having a shield and a conductor enclosed within the shield.

A fault is defined herein as any unintended perturbation in the path of a conductor that undesirably draws current therefrom, such as a short, a cross, a ground, or a split. For purposes of illustration, the fault 20 disclosed herein is characterized as a resistance fault, it being understood that the device 10 is applicable to the location of many types of faults as generally defined above.

The locator unit 12 is operably positioned proximal to a locator point 32 on the paired line 18 that is between the base point 26 and terminator point 28. As such, the locator unit 12 preferably does not electrically engage the conductors 22, 24, but is sufficiently proximal to the conductors 22, 24 to produce an induced signal therein as will be described hereafter. The base and terminator points 26, 28 are preferably selected at points on the paired line 18 where relatively convenient electrical access to the conductors 22, 24 is provided, such as a junction box or other splice location. Electrical communication is provided between the base unit 14 and the conductors 22, 24 by base pickup lines 34, 36 extending from the base unit 14 and having electrically conductive pickups such as conventional alligator clips or the like on the ends of the lines 34, 36 that are removably connected to the conductors 22, 24. A base ground line 38 is also provided connecting the base unit 14 to a ground 40. Similarly, electrical communication is provided between the terminator unit 16 and the conductors 22, 24 by terminator pickup lines 42, 44 extending from the terminator unit 16 and removably connected to the conductors 22, 24. A terminator ground line 46 is provided connecting the terminator unit 16 to a ground 48.

As will be described in greater detail hereafter with respect to the method of operation, the position of the base point 26, and correspondingly the position of the base unit 14, are substantially fixed with respect to the paired line 18 during a given fault locating sequence. The position of the terminator point 28, and correspondingly the position of the terminator unit 16, are likewise substantially fixed with respect to the paired line 18 during a given fault locating sequence. In contrast, the position of the locator point 32 is variable along the length of the paired line 18 throughout a given fault locating sequence as a function of the fixed position of the fault 20 on the paired line 18. Accordingly, the locator unit 12 has a fully mobile, unanchored, portable configuration, the locator unit 12 being relatively compact and lightweight to render it manually transportable by a single operator. In the embodiment of Figure 1, the locator unit 12 is shown to comprise a unitary housing 50 and a probe 52 positioned outside the housing 50. A connective member 53 extends between the probe 52 and the housing 50. The housing 50 is preferably a hardened protective shell and the connective member 53 is preferably a flexible or rigid tube. Although not shown, the probe 52 can alternatively be positioned within the housing 50, thereby eliminating the connective member 53.

The specific components of the locator unit 12 are described with further reference to the block diagram of Figure 2. The probe 52 is shown schematically to enclose a coil 54 electrically connected by coil lines 56a, 56b to the circuitry of the locator unit 12. The coil 54 can have a number of configurations depending on the specific application of the fault locating device 10. For locating faults in an inaccessible paired line, a relatively large remote coil is provided, typically having an elongated magnetic core or other geometry sufficient to meet the performance requirements of the locator unit 12. For locating faults in an accessible paired line, a relatively small contact coil is provided.

The circuitry of the locator unit 12 comprises a locator signal transmission circuit 58 and a carrier signal processing circuit 60. The locator signal transmission circuit 58 provides a pathway from a microcontroller 62 to the coil 54 for a locator signal capable of producing a magnetic induced signal in the paired line 18. Included in series within the locator signal transmission circuit 58 in a direction away from the microcontroller 62 toward the coil line 56a are a synchronized oscillator 64, a locator signal power driver 66, and a carrier signal rejection filter 68. The locator signal transmission circuit 58 and the carrier signal processing circuit 60 are in electrical communication with the coil 54 via the coil line 56a.

The carrier signal processing circuit 60 provides a pathway for a carrier signal from the coil 54 to the microcontroller 62. Included in series within the carrier signal processing circuit 60 in the direction away from the coil line 56a toward the microcontroller 62 are a locator signal rejection filter 72, a carrier signal preamplifier 74, a switch 76 and a carrier signal receiver 78. The carrier signal processing circuit 60 splits into two parallel pathways after the carrier signal receiver 78 with a first parallel pathway 80 including a limiter 82 and a decoder 84 and a second parallel pathway 86 including a magnitude detector 88. As used herein, the term "limiter" is defined to encompass a conventional limiter or, in the alternative, an automatic gain control.

The first and second parallel pathways 80, 86 feed into the microcontroller 62 through an analog to digital converter 90. The locator unit 12 is further provided with a visual display 92 and an audio speaker 94 in parallel electrical communication with the microcontroller 62, enabling the locator unit 12 to communicate an indicator both visually and audibly to an operator of the device 10.

The microcontroller 62 disclosed herein is a digital microprocessor. It is nevertheless apparent to the skilled artisan that within the scope of the present invention an analog controller can be substituted for the digital microprocessor within the circuits 58, 60 without substantially altering the capabilities of the present fault locating device 10. The analog to digital converter 90 is omitted from the carrier signal processing circuit 60 in the case where an analog controller is substituted for a digital microprocessor as the microcontroller 62. A DC power source 96 is additionally included in the housing 50 of the locator unit 12. The power source 96 supplies power to the components of the locator unit 12 enabling the functions thereof. The power source 96 is preferably a relatively small, lightweight battery pack, such as one or more dry-cell or rechargeable batteries (e.g., 9-volt or D-cell batteries).

It is noted that the microcontroller 62, synchronized oscillator 64 and decoder 84 are shown and described herein as discrete structural components having related functions. In practice, these discrete components can be integrated into a single digital microprocessor structure performing the same functions ascribed to the discrete components in a manner apparent to the skilled artisan.

It is additionally noted that the switch 76 of locator unit 12 has two functional positions providing alternate capabilities therefor. When the switch 76 is in the position shown, the coil 54 and carrier signal processing circuit 60 function as a magnetic carrier signal pickup, primarily for receiving magnetic carrier signals from the base unit 14 as described hereafter. By selectively repositioning the switch 76, a capacitive ground reference circuit 98 is enabled which, in cooperation with the coil 54, functions as a capacitive pickup primarily for locating cable shield breaks as described hereafter. The capacitive ground reference circuit 98 includes a capacitive ground reference 100 and a capacitive signal preamplifier 102 on one side of the switch 76. The remainder of the capacitive ground reference circuit 98 on the opposite side of the switch 76 is identical to the carrier signal processing circuit 60, including the carrier signal receiver 78, first and second parallel pathways 80, 86, analog to digital converter 90 and microprocessor 62.

If the housing 50 of the locator unit 12 is electrically conductive, the capacitive ground reference 100 is simply the housing 50. If the housing 50 is not electrically conductive, however, the capacitive ground reference 100 can be provided by a metallic shield (not shown) contained within the housing 50. In either case, the capacitive ground reference 100 couples to the body of an operator, which provides adequate ground reference for a carrier signal when the operator is standing on the earth. Although not shown, the capacitive ground reference 100 can alternatively be a grounding lead and grounding connection connected to a cable shield.

It is further noted that the circuitry of the locator unit 12 further comprises a locator circuit common 104. The locator circuit common 104 is electrically connected to the locator signal power driver 66, carrier signal preamplifier 74 and capacitive carrier preamplifier 102.

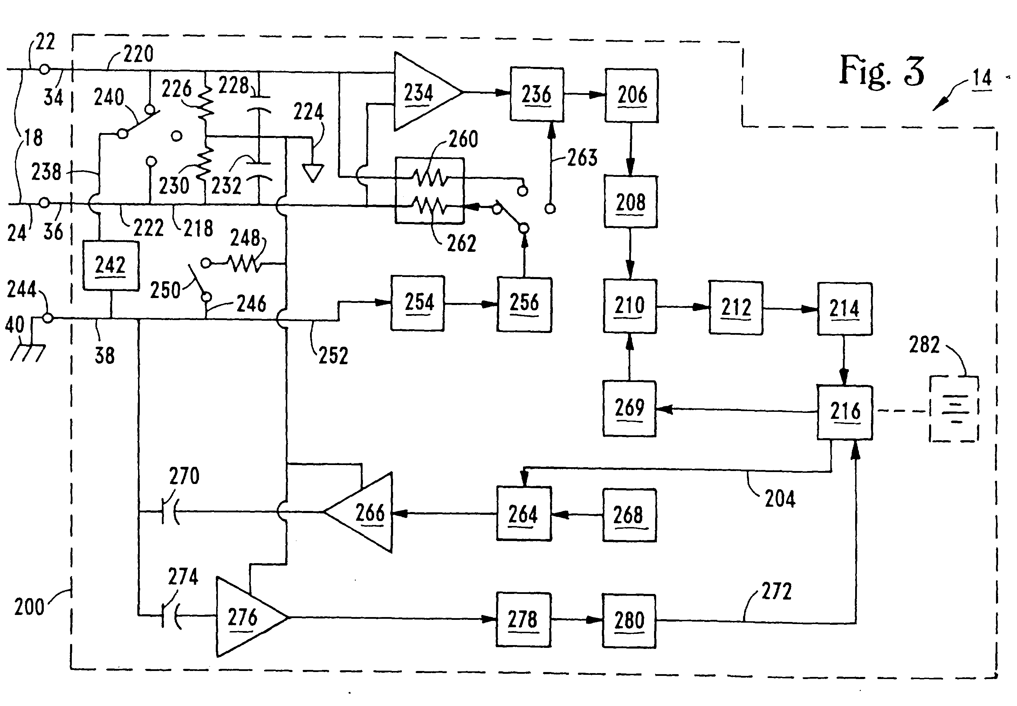

The specific components of the base unit 14 are described with further reference to the block diagram of Figure 3. Substantially all of the circuitry of the base unit 14 is enclosed in a housing 200 comprising a hardened protective shell. The circuitry of the base unit 14 includes an induced signal receiver circuit 202 and a base unit carrier signal transmission circuit 204. As described above, the base pickup lines 34, 36 extend from the base unit 14 and removably connect with the conductors 22, 24 to provide electrical communication between the circuits 202, 204 and the paired line 18. The induced signal receiver circuit 202 is configured to receive the induced signal originating at the locator point 32 and sent therefrom along the paired line 18. Included in series within the induced signal receiver circuit 202 in a direction away from the paired line 18 are a variable gain amplifier 206, a bandpass filter 208, a synchronous detector 210, a lowpass filter 212, an analog to digital converter 214 and a microcontroller 216. Incorporated within the induced signal receiver circuit 202 is a low impedance input termination 218 positioned between the base pickup lines 34, 36 and the variable gain amplifier 206.

The low impedance input termination 218 comprises a first inlet pathway 220 and a second inlet pathway 222. The first inlet pathway 220 is connected to a base circuit common 224 through a first balanced resistor 226 and a first balanced capacitor 228 in parallel. The second inlet pathway 222 is connected to the base circuit common 224 through a second balanced resistor 230 and a second balanced capacitor 232 in parallel. The first and second balanced resistors 226, 230 are substantially equal in resistance to provide, in series, an input terminating resistance across the base pickup lines 34, 36. As such, the first and second balanced resistors 226, 230 provide a balanced center tap of the low impedance input termination 218 connected to the base circuit common 224. The first and second balanced capacitors 228, 232 are also substantially equal in value to provide a relatively low impedance path from the base pickup lines 34, 36 to the base circuit common 224 for the higher frequency carrier signals while providing a balanced relatively high impedance to the lower frequency induced signal. The first and second inlet pathways 220, 222 feed into a differential signal preamplifier 234 that is connected in series to a summing amplifier 236 and the variable gain amplifier 206.

A line balancing pathway 238 is provided having a balancing switch 240 that enables selective connection of the first or second inlet pathway 220 or 222 to the base grounding line 38 through a line balancing variable impedance 242. The base ground line 38 is connected to the ground 40 by a ground pickup 244. A switching line 246 extends from the base ground line 38 having a resistor 248 and a grounding switch 250 in series. When closed, the grounding switch 250 connects the base circuit common 224 to the ground 40 through the resistor 248.

A noise nulling circuit 252 feeds into the low impedance input termination 218 from the base ground line 38. The noise nulling circuit 252 includes in series a variable gain amplifier 254, a variable phase shifter 256, and a three-way switch 258. A first position of the switch 258 connects the noise nulling circuit 252 with the first inlet pathway 220 through a first summing impedance 260, a second position of the switch 258 connects the noise nulling circuit 252 with the second inlet pathway 222 through a second summing impedance 262, and a third position of the switch 258 connects the noise nulling circuit 252 with the summing amplifier 236 through a summing input line 263.

The base carrier signal transmission circuit 204 is configured to send an encoded carrier signal from the base unit 14 along the paired line 18 to the locator unit 12 and the terminator unit 16. Included in series within the base carrier signal transmission circuit 204 in the direction of the paired line 18 are the microcontroller 216, an encoder 264, and a carrier signal driver 266. A carrier signal oscillator 268 electrically communicates with the encoder 264 and a locator synchronization oscillator 269 is provided in electrical communication with the microcontroller 216 and the synchronous detector 210. The carrier signal driver 266 is referenced to the base circuit common 224 and connected to the base grounding line 38 through a capacitor 270.

The base unit 14 is also provided with a terminator carrier signal receiver circuit 272 configured to receive an encoded carrier signal originating at the terminator unit 16 and sent to the base unit 14 along the paired line 18. The carrier signal receiver circuit 272 is connected to the base ground line 38 through a capacitor 274. Included in series within the terminator carrier signal receiver circuit 272 in a direction away from the capacitor 274 are a carrier signal receiver 276, a limiter 278, a decoder 280, and the microcontroller 216. The microcontroller 216 disclosed herein is a digital microprocessor. It is nevertheless apparent to the skilled artisan that within the scope of the present invention an analog controller can be substituted for the digital microprocessor within the circuits 202, 204, 272 without substantially altering the capabilities of the present fault locating device 10. The analog to digital converter 214 is omitted from the induced signal receiver circuit 202 in the case where an analog controller is substituted for a digital microprocessor as the microcontroller 216. A DC power source 282 is additionally included in the housing 200 of the base unit 14. The power source 282 supplies power to the components of the base unit 14 enabling the functions thereof. The power source 282 is preferably one or more relatively small, lightweight batteries.

It is noted that the microcontroller 216, encoder 264, decoder 280 and oscillators 268, 269 are shown and described herein as discrete structural components having related functions. In practice, these discrete components can be integrated into a single digital microprocessor structure performing the same functions ascribed to the discrete components in a manner apparent to the skilled artisan.

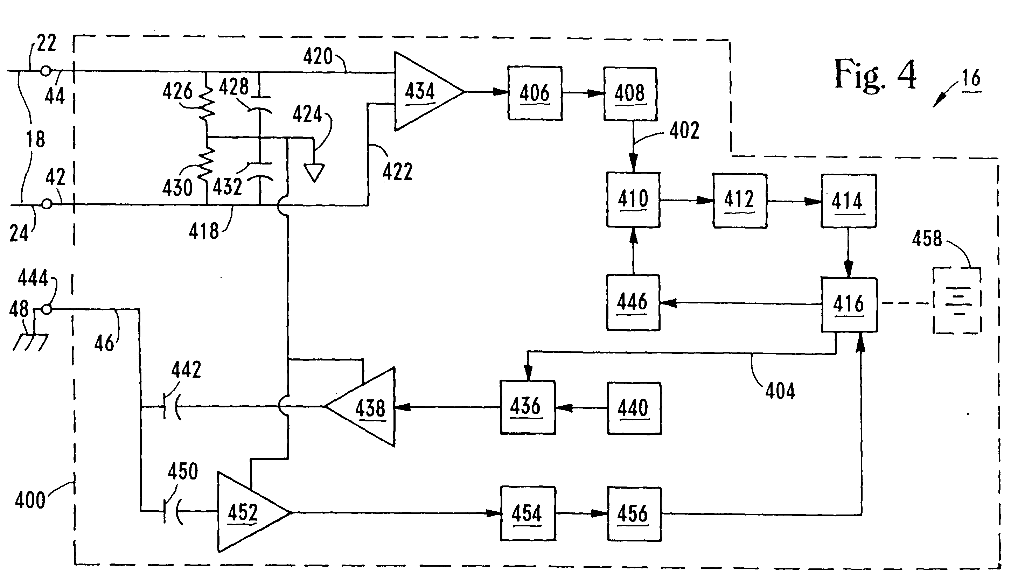

The specific components of the terminator unit 16 are described with further reference to the block diagram of Figure 4. Substantially all of the circuitry of the terminator unit 16 is enclosed in a housing 400 comprising a hardened protective shell. The circuitry of the terminator unit 16 includes an induced signal receiver circuit 402 and a terminator carrier signal transmission circuit 404. As described above, the terminator pickup lines 42, 44 extend from the terminator unit 16 and connect with the conductors 22, 24 to provide electrical communication between the circuits 402, 404 and the paired line 18. The induced signal receiver circuit 402 is configured to receive the induced signal originating at the locator point 32 and sent therefrom along the paired line 18. Accordingly, the induced signal receiver circuit 402 of the terminator unit 16 is substantially similar to the induced signal receiver circuit 202 of the base unit 14 shown in Figure 3. Included within the induced signal receiver circuit 402 in a direction away from the paired line 18 are a variable gain amplifier 406, a bandpass filter 408, a synchronous detector 410, a lowpass filter 412, an analog to digital converter 414 and a microcontroller 416. Further included within the induced signal receiver circuit 402 is a high impedance input termination 418 positioned between the terminator pickup lines 42, 44 and the variable gain amplifier 406. The high impedance input termination 418 is specified to provide a relatively high impedance to the induced signal voltage so that the terminator unit 16 does not draw induced signal current past the fault as is described hereafter.

The high impedance input termination 418 comprises a first inlet pathway 420 and a second inlet pathway 422. The first inlet pathway 420 is connected to a terminator circuit common 424 through a first balanced resistor 426 and a first balanced capacitor 428 in parallel. The second inlet pathway 422 is connected to the terminator circuit common 424 through a second balanced resistor 430 and a second balanced capacitor 432 in parallel. The first and second balanced resistors 426, 430 are substantially equal in resistance, having a relatively high value on the order of about 1 megohm to provide in series an input terminating resistance across the terminator pickup lines 42, 44. As such, the first and second balanced resistors 426, 430 provide a balanced center tap of the high impedance input termination 418 connected to the terminator circuit common 424. The first and second balanced capacitors 428, 432 are also substantially equal in value to provide a relatively low impedance path from the terminator pickup lines 42, 44 to the terminator circuit common 424 for the higher frequency carrier signals while providing a balanced relatively high impedance to the lower frequency induced signal. The first and second inlet pathways 420, 422 feed into a differential signal preamplifier 434 that is connected in series to the variable gain amplifier 406.

The terminator carrier signal transmission circuit 404 is configured to send an encoded carrier signal from the terminator unit 16 along the paired line 18 to the base unit 14. Accordingly, the carrier signal transmission circuit 404 of the terminator unit 16 is substantially similar to the carrier signal transmission circuit 204 of the base unit 14 shown in Figure 3. Included in series within the terminator carrier signal transmission circuit 404 in the direction of the paired line 18 are the microcontroller 416, an encoder 436, and a carrier signal driver 438. A carrier signal oscillator 440 communicates with the encoder 436. The carrier signal driver 438 is connected to the terminator ground line 46 through a capacitor 442 and a terminator ground pickup 444. A terminator synchronization oscillator 446 is provided in electrical communication with the microcontroller 416 and the synchronous detector 410.

The terminator unit 16 is also provided with a base carrier signal receiver circuit 448 configured to receive an encoded carrier signal originating at the base unit 14 and sent to the terminator unit 16 along the paired line 18. The carrier signal receiver circuit 448 is connected to the terminator ground line 46 through a capacitor 450. Included in series within the base carrier signal receiver circuit 448 in a direction away from the capacitor 450 are a carrier signal receiver 452, a limiter 454, a decoder 456, and the microcontroller 216.

The microcontroller 416 disclosed herein is a digital microprocessor. It is nevertheless apparent to the skilled artisan that within the scope of the present invention an analog controller can be substituted for the digital microprocessor within the circuits 402, 404 without substantially altering the capabilities of the present fault locating device 10. The analog to digital converter 414 is omitted from the induced signal receiver circuit 402 in the case where an analog controller is substituted for a digital microprocessor as the microcontroller 416. A DC power source 458 is additionally included in the housing 400 of the terminator unit 16. The power source 458 supplies power to the components of the terminator unit 16 enabling the functions thereof. The power source 458 is preferably one or more relatively small, lightweight batteries.

It is noted that the microcontroller 416, encoder 436, decoder 456 and oscillators 440, 446 are shown and described herein as discrete structural components having related functions. In practice, these discrete components can be integrated into a single digital microprocessor structure performing the same functions ascribed to the discrete components in a manner apparent to the skilled artisan.

### Method of Operation

Operation of the fault locating device 10 is described with reference to Figures 1-4. At the outset, a segment 30 of a paired line 18 is identified that is believed to contain a fault 20. The paired line segment 30 is typically up to about 5000 meters in length and can comprise the entire length of the paired line 18, if the paired line is 5000 meters or less in length. The base unit 14 is fixably positioned at a base point 26 that is at one end of the paired line segment 30 and the terminator unit 16 is fixably positioned at a terminator point 28 that is at the other end of the paired line segment 30. The base pickup lines 34, 36 are removably connected to the first and second conductors 22, 24 at the base point 26 and the terminator pickup lines 42, 44 are similarly removably connected to the first and second conductors 22, 24 at the terminator point 28.

The method of locating the fault 20 is initiated by positioning the probe 52 of the locator unit 12 proximal to a selected locator point 32 on the paired line 18 between the base point 26 and terminator point 28. The actual position of the locator point 32 is variable, rather than fixed, during operation of the fault locating device 10. The locator point 32 is preferably positioned near the base point 28 during initial operation of the device 10 such that the fault 20 is located somewhere along the paired line segment 30 between the locator point 32 and the terminator point 28. The locator point 32 is then incrementally repositioned toward the terminator point 28 as operation of the device 10 proceeds. The relative distance between the probe 52 and conductors 22, 24 at any given locator point 32 is termed the induction distance. The maximum allowable induction distance is a function of the power output of the locator unit 12, the size and configuration of the coil 54, and the desired voltage of the signal induced in the conductors 22, 24. A typical maximum allowable induction distance is up to about 1 meter using a relatively large remote induction coil 54 for inaccessible buried paired cable and up to about 0.06 meters using a relatively smaller contact induction coil 54 for accessible paired cable.

The microprocessor 62 directs the synchronized oscillator 64 and locator signal power driver 66 to generate a synchronized AC locator signal utilizing the DC power source 96. The resulting locator signal is sent to the coil 54 via the locator signal transmission circuit 58 where the coil 54 magnetically couples the locator signal into the paired line 18 to produce a magnetic induced signal in the paired line 18 at the locator point 32. The voltage and frequency of the induced signal are selected within ranges that satisfy the performance requirements of the fault locating device 10. In particular, the voltage and frequency ranges of the induced signal are limited at the upper end by the requirement that the induced signal on the paired line 18 be inaudible to listeners and by the requirement that the induced signal on the paired line 18 avoid excessive carry-by. Generally, a signal having both a very low voltage and a very low frequency satisfies the requirements of being inaudible and avoiding significant carry-by. Such a signal, however, may fail to satisfy other performance requirements of the device 10, lacking sufficient voltage to exceed the background noise and lacking sufficient frequency to be coupled onto the paired line 18 by the coil 54. If the frequency of the induced signal is raised to improve the detectability thereof, the induced signal may become overly susceptible to carry-by. Alternatively, if the voltage of the induced signal is raised to overcome the background noise, excessive battery power may become necessary, defeating the portability of the detector unit 12. Particularly high background noise levels are observed where resistance between the conductors 22, 24 creates an unbalanced condition in the paired line 18 that allows the induced 50/60 Hz voltage and 35 Hz noise normally present common mode to ground on the conductors 22, 24 of the paired line 18 to be coupled into the paired line 18, appearing as differential noise between the conductors 22, 24.

In the present illustrative embodiments selection of the voltage and frequency of the induced signal requires a balancing of competing factors to achieve the required fully-portable fault locating device 10 having an inaudible, yet detectable, induced signal, that exceeds the background noise on the paired line 18 while avoiding the effects of excessive carry-by. Achievement of these performance requirements is facilitated by noise nulling circuitry that reduces the noise on the paired line 18 and synchronization circuitry that mitigates the impact of carry-by, as described hereafter. As such, the frequency of the induced signal is typically selected in a range less than about 300 Hz, preferably in a range between about 200 Hz and about 1 Hz, and most preferably at a value of about 35 Hz. The corresponding voltage of the induced signal is typically selected in a range between about 0.1 microvolt and 100 microvolts and preferably at a value of about 1 microvolt, which is generally greater than ambient noise after noise nulling.

The induced signal satisfying the above-recited criteria travels along the conductors 22, 24 to the base unit 14 and the terminator unit 16. With the locator point 32 positioned between the base point 26 and the fault 20, the base pickup lines 34, 36 receive the induced signal and carry the induced signal to the induced signal receiver circuit 202 having the noise nulling circuitry incorporated therein. The differential signal preamplifier 234 amplifies the induced signal received by the low impedance input termination 218 from the base pickup lines 34, 36. The differential signal preamplifier 234 is also equipped with a DC blocking mechanism to remove DC biases present on the paired line 18. The summing amplifier 236 adds the output of the differential signal preamplifier 234 to the output of the noise nulling circuit 252 enabling the operator to reduce the effects of noise on the conductors 22, 24 received by the base unit 14. In particular, noise nulling enables the operator to cancel the unbalanced voltage on the paired line 18 by summing a portion of the common mode voltage present between the conductors 22, 24 and the ground 40 at the base point 26 with the differential voltage present across the paired line 18, in proper phase and magnitude. Summing of these voltages causes substantial cancellation of the noise induced onto the paired line 18 by the unbalance often present at the fault 20.

The noise nulling circuitry effectuates noise nulling by means of the low impedance input termination 218. The first and second balanced resistors 226, 230 of the low impedance input termination 218 are connected to the base circuit common 224 having a high impedance to earth ground, thereby functioning to reject common mode signals to ground while referencing the base circuit common 224 to the common mode (longitudinal) voltage present on the conductors 22, 24. The low impedance input termination 218 is augmented by selecting one or more of the noise nulling techniques described hereafter that are enabled by the circuitry of the base unit 14.

In accordance with a technique termed summing amplifier nulling, the common mode voltage of the induced signal between the conductors 22, 24 and the ground 40 is processed by the variable gain amplifier 254 and the variable phase shifter 256 and summed into the summing amplifier 236. The gain and phase of the induced signal are adjusted to null the imbalance voltage beyond the summing amplifier 236. An alternate technique termed summing impedance nulling likewise processes the common mode voltage with the variable gain amplifier 254 and the variable phase shifter 256. The resulting signal, however, is applied to one side of the low impedance input termination 218 through the summing impedance 260, 262 or a resistor (not shown) substituted therefor, while the switch 258 disconnects the summing input line 263 causing the summing amplifier 236 to function as a buffer amplifier for signals from the differential signal preamplifier 234. Proper adjustment of the gain and phase balances out the noise at the input to the differential signal preamplifier 234 and simultaneously reduces the noise level on the conductors 22, 24.

In accordance with a technique termed line balancing variable impedance adjustment, the common mode voltage on either the first or the second inlet pathway 220, 222, as selected by the switch 230, is passed through the line balancing variable impedance 242, selecting whichever inlet pathway 220 or 222 produces the greatest noise cancellation. If required, the line balancing variable impedance 242 is also adjusted to minimize noise. This technique is particularly effective when the unbalance is very large, such as in the case of unbalanced shunting impedances, and may be supplemented by either of the two previously recited techniques.

A technique termed line balancing with grounded termination center tap also has utility in conjunction with either of the previously recited techniques. In accordance with this technique, the grounding switch 250 is closed, effectively grounding the center tap of the low impedance input termination 218. The switch 240 is closed to the side of the inlet pathway 220 or 222 producing the greatest noise cancellation. The line balancing variable impedance 242 is then adjusted, if required, to minimize noise.

The output of the summing amplifier 236 passes to the variable gain amplifier 206 where the voltage of the induced signal is further amplified and, if desired, adjusted for differences in the signal due to fault resistance losses. The bandpass filter 208, which is tuned to the relatively low frequency of the induced signal, rejects extraneous signals from the output of the variable gain amplifier 206 that have surrounding frequencies. In particular, the bandpass filter 208 attenuates interference from 50/60 Hz signals that are magnetically induced onto the paired line 18 by adjacent power lines.

The synchronous detector 210 is driven by the locator synchronization oscillator 269 which is synchronized with generation of the locator signal at the locator unit 12, thereby synchronizing operation of the base unit 14 and locator unit 12. Synchronous operation of the base unit 14 and locator unit 12 in conjunction with the use of an induced signal having a relatively low frequency enables the effective location of faults having resistances above 50 kohms without a significant impact from carry-by, even in relatively long paired line segments 30 having lengths up to 5000 meters. Low frequency operation tends to decrease carry-by because lowering the frequency of the induced signal increases the capacitive reactance of the paired line 18, reducing the magnitude of induced signal current flow past the fault 20. The synchronous detector 210 supplements this effect by detecting only the current of the induced signal flowing through the fault resistance and rejecting any carry-by occurring due to current flow into capacitance that leads resistive current by 90°. The low frequency induced signal has the added advantage of exhibiting substantially less attenuation over length of the paired line segment 30 than would a higher frequency induced signal. Synchronous detection further enables the operator to observe changes in polarity due to twisting of the conductors 22, 24. This permits the operator to differentiate between carry-by and the induced signal in the presence of unbalanced conductor faults and ground faults both of which are more susceptible to carry-by than balanced conductor faults.

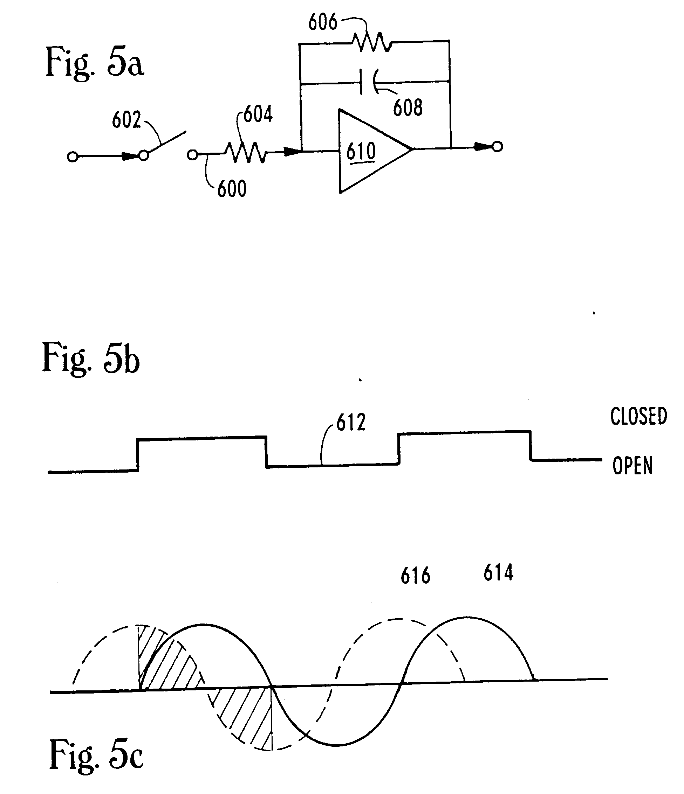

The principle by which the synchronous detector 210 operates is described with reference to Figure 5a, 5b and 5c. Operation of the synchronous detector 210 in association with the fault locating device 10 of Figure 1 is the functional equivalent of a circuit 600 shown in Figure 5a. The circuit 600 has a switch 602 that is opened and closed in synchronism with the induced signal at the locator unit 14. The circuit 600 further includes a series resistor 604 and, in parallel, a resistor 606, a capacitor 608 and an amplifier 610 such that the output voltage of the circuit 600 is the average input voltage of the circuit 600 when the switch 602 is closed. The switch 602 is opened and closed as shown in Figure 5b by the switch waveform 612. Figure 5c shows the input voltage waveform of the circuit 600 as the sum of two distinct waveforms, a resistance current waveform 614 and a capacitance current waveform 616.

By opening and closing the switch 602 in synchronism with the input voltage waveform, in accordance with the relationship shown in Figures 5b and 5c, the capacitance current waveform 616 of the carry-by leads the resistance current waveform 614 by 90°, thereby averaging to zero as indicated by the shaded area under the capacitance current waveform 616 of Figure 5c. In contrast, the entire fault resistance current waveform 614 is in phase with the induced signal and the switch waveform 612, thereby enabling detection of the resistance fault.

Referring again to Figure 3 and the operation of the base unit 14, the lowpass filter 212 filters the rectified DC signal from the synchronous detector 210, allowing a narrowing of the circuit bandwidth to more effectively filter out 50/60Hz signals and other extraneous signals having undesired frequencies. The analog to digital converter 214 converts the analog voltage values of the DC signal produced by the lowpass filter 212 to digital values for processing by the microcontroller 216 which is shown herein to be a digital microprocessor. It also is within the purview of the skilled artisan to substitute an analog controller for a digital microprocessor as the microcontroller 216, in which case the analog to digital converter 214 is omitted from the base unit 14. In either case, the microcontroller 216 configures the circuitry of the base unit 14 for its various modes of operation, including receiving and reading the induced signal and encoding and sending a carrier signal. In particular, the microcontroller 216 specifies values of an induced signal characteristic that are encoded onto a carrier signal created by the base unit 14 and sent to the locator unit 12. For purposes of fault location, the induced signal is disclosed herein as being characterized in terms of the magnitude of its voltage. However, it is understood that within the scope of the present invention, the induced signal can alternatively be specified in terms of characteristics other than voltage magnitude, such as phase shifts.

Regardless of which characteristic is selected to specify the induced signal, the carrier signal transmission circuit 204 of the base unit 14 creates a carrier signal having values of the selected characteristic for the induced signal and having synchronization marks encoded therein. The synchronization marks enable the locator unit 12 to create the induced signal in synchronization with operation of the synchronous detector 210 at the base unit 14 so that carry-by is reduced. For example, the encoded base carrier signal is created by delivering values of the voltage magnitude of the induced signal measured at the base unit 12 from the microcontroller 216 to the encoder 264. The synchronization marks are similarly delivered from the microcontroller 216 to the encoder 264. The encoder 264 imprints this information onto the base carrier signal in the form of a digital or analog code.

The encoded base carrier signal is sent in synchronization with the locator unit 12 by means of the carrier signal oscillator 268 and carrier signal driver 266 to the locator unit 12. In particular, the carrier signal driver 266 drives the carrier signal current out through the capacitor 270 and ground pickup 244 to the ground 40, forcing an opposing current flow from the carrier signal driver 266, into the base circuit common 224, through the first and second balanced capacitors 228, 232, into the base pickup lines 34, 36, and onto the paired line 18. The capacitor 270 provides a low impedance path to the ground 40 for the carrier signal while providing a high impedance for the induced signal from the locator unit 12. Unlike the induced signal, the encoded base carrier signal has a frequency range greater than about 5 kHz, preferably a frequency range between about 5 kHz and about 100 kHz, and most preferably a frequency value of about 10 kHz. The encoded base carrier signal typically has a voltage below about 150 volts within the prescribed frequency range and preferably has a voltage of about 25 volts.

When the encoded base carrier signal reaches the locator unit 12 via the conductors 22, 24, the base carrier signal is received magnetically by the coil 54 within the probe 52 positioned at the locator point 32. The base carrier signal is sent along the coil line 56a to the carrier signal receiver circuit 60 while entry to the locator signal transmission circuit 58 is blocked by means of the carrier signal rejection filter 68. The carrier signal passes through the locator signal rejection filter 72, which blocks entry of the locator signal into the carrier signal processing circuit 60, and is fed to the carrier signal preamplifier 74. The carrier signal is amplified in the carrier signal preamplifier 74 and delivered to the carrier signal receiver 78 through the closed switch 76. The carrier signal receiver 78 feeds the amplified signal to the limiter 82 where the amplitude of the signal is limited thereby and then to the decoder 84 where the encoded information on the carrier signal is read. The decoded information, which comprises the synchronization marks and values of the selected characteristic specifying the induced signal (in this case voltage magnitude measured at the base unit 14), is transmitted from the decoder 84 to the microcontroller 62 for processing after the decoded information is passed through the analog to digital converter 90 for digital conversion.

The magnitude detector 88 simultaneously evaluates the amplified signal from the carrier signal receiver 78 to determine the magnitude of the carrier signal for processing by the microcontroller 62, whether the signal has originated from the magnetic carrier receiver circuit 58 or the capacitive ground reference circuit 102, as will be described hereafter. The magnitude detector 88 sends values of the magnitude of the carrier signal to the microcontroller 62 after it has passed through the analog to digital converter 90 for digital conversion. As previously noted, it is within the purview of the skilled artisan to substitute an analog controller for a digital microprocessor as the microcontroller 62, in which case the analog to digital converter 90 is omitted from the locator unit 12.

The microcontroller 62 directs operation of the synchronized oscillator 64, display 92, speaker 94 in correspondence with the decoded information received from the decoder 84. For example, the synchronization marks are translated into instructions that are sent to the synchronized oscillator 64 for synchronized operation thereof. Values of the voltage magnitude for the induced signal are similarly translated into instructions that are sent to the speaker 94 for generating a audible correlation of the voltage magnitude in the form of a continuous audible tone having an intensity or frequency directly related to the values of the voltage magnitude for the induced signal received by the base unit 14. As the voltage magnitude increases, the intensity or frequency of the tone generated by the speaker 94 increases. Correspondingly, as the voltage magnitude decreases, the intensity or frequency of the tone generated by the speaker 94 decreases.

The presence of the fault 20 causes a drop in the magnitude of the voltage for the induced signal, because the voltage of the induced signal divides between the resistance of the fault 20 and the low resistance of the low impedance input termination 218 of the base unit 14. When the fault resistance draws current, current also flows through the low impedance input termination 218 producing a voltage drop detectable by the base unit 14. If the locator unit approaches the fault 20 from the base point 26, the base unit 14 will detect voltage due to current flow in the fault resistance. The magnitude of this voltage may rise and fall and reverse in polarity as the coil 54 is moved along the paired cable containing the paired line segment 30 due to the twist of the conductors 22, 24 and the spiraling of the paired line segment 30 within the paired cable, but will remain continuous before the fault 20 is reached. Polarity changes can be communicated to the operator by a change in a characteristic of the audible tone in correspondence with polarity changes. In any case, when the locator unit 12 passes the fault 20, the base unit 14 no longer detects any voltage, while the terminator unit 16 detects full voltage as described hereafter.

Thus, the fault 20 in the segment 30 of the paired line 18 is located by shifting the locator unit 12 along the segment 30 away from the base point 26 in the direction of the terminator point 28 to establish incrementally new locator points 32 therebetween. The fault 20 is precisely located at the point on the segment 30 where the intensity or frequency of the tone from the speaker 94 is strong followed by an abrupt drop in the intensity or frequency of the tone as the locator unit 12 continues in the direction of the terminator point 28. The display 92 provides a quantitative visual verification of the information communicated to the operator by the speaker 94. The display 92 is a visual correlation of the voltage magnitude in the form of either an analog or a digital readout of the values of the voltage magnitude for the induced signal as the locator unit 12 is conveyed along the paired line 18.

The terminator unit 16 supplements the present method of fault location by providing an auxiliary encoded carrier signal responsive to the induced signal of the locator unit 12. The encoded carrier signal of the terminator unit 16 confirms location of the fault 20 when read in conjunction with the encoded carrier signal of the base unit 14. In operation, the induced signal originating at the locator point 32 travels to the terminator point 28 where it is received by the terminator unit 16 and processed in a manner similar to that of the base unit 14. In particular, the induced signal is delivered from the conductors 22, 24 to a high impedance input termination 418 by the terminator pickup lines 42, 44 that are removably connected to the conductors 22, 24. The high impedance input termination 418 is balanced in substantially the same manner as the low impedance input termination 218 of the base unit 14, but lacks the associated noise nulling circuitry of the base unit 14 because the termination unit 16 receives a stronger signal than the base unit 14 that is not attenuated by fault resistance. The termination unit 16 also has a high input impedance preventing it from drawing the induced signal when the locator unit 12 is between the fault 20 and the terminator unit 16.

The differential signal preamplifier 434 receives the induced signal from the high impedance input termination 418 and amplifies the induced signal. The output of the differential signal preamplifier 418 passes to the variable gain amplifier 406 where the voltage of the induced signal is further amplified and, if desired, adjusted for differences in the signal due to coil coupling losses. The bandpass filter 408, which is tuned to the relatively low frequency of the induced signal, rejects extraneous signals from the output of the variable gain amplifier 406 that have surrounding frequencies. In particular, the bandpass filter 408 attenuates interference from 50/60 Hz signals that are magnetically induced onto the paired line 18 by adjacent power lines. The synchronous detector 410 in conjunction with the locator synchronization oscillator 264 functions to detect the induced signal in synchronism with the locator signal generated by the locator unit 12 and induced into the paired line 18 by the coil 54. It is noted, however, that since capacitance does not cause a substantial capacitive component in the voltage received by the terminator unit 16, a standard detector may alternatively be substituted for the synchronous detector 410 of the terminator unit 16 without significant loss of performance. In any case, synchronous operation of the terminator unit 16 is substantially similar to that described above with respect to the base unit 14 such that the terminator unit 16 detects the induced signal in synchronization with generation of the signal at the locator unit 12 and sends the terminator carrier signal in synchronization with receipt of the carrier signal from the base unit 14.

The lowpass filter 412 filters the rectified DC signal from the synchronous detector 410, allowing a narrowing of the circuit bandwidth to more effectively filter out 50/60Hz signals and other extraneous signals having undesired frequencies. The analog to digital converter 414 converts the analog voltage values of the DC signal produced by the lowpass filter 412 to digital values for processing by the microcontroller 416 which is shown herein to be a digital microprocessor. It is also within the purview of the skilled artisan to substitute an analog controller for a digital microprocessor as the microcontroller 416, in which case the analog to digital converter 414 is omitted from the terminator unit 16. In either case, the microcontroller 416 configures the circuitry of the terminator unit 16 for its various modes of operation, including receiving and reading the induced signal and encoding and sending a carrier signal.

The carrier signal transmission circuit 404 of the terminator unit 16 creates a terminator carrier signal having values of the voltage magnitude for the induced signal encoded thereon. As noted above, an alternate characteristic specifying the induced signal can be selected, such as phase shift. The terminator carrier signal is created by delivering values of the selected characteristic for the induced signal (i.e., values of the voltage magnitude in this case) measured at the terminator unit 16 from the microcontroller 416 to the encoder 436. The encoder 436 imprints this information onto the terminator carrier signal in the form of a digital or analog code. The encoded terminator carrier signal is then transmitted in synchronization with the base unit 14 by means of the oscillator 440 and carrier signal driver 438 to the base unit 14 via the terminator pickup lines 42, 44 and the conductors 22, 24 of the paired line 18. The encoded terminator carrier signal is similar to the base carrier signal insofar as it has a frequency range greater than about 5 kHz, and preferably between about 5 kHz and about 100 kHz. The terminator carrier signal most preferably has a frequency value of about 10 kHz when time multiplexed with the base carrier signal or about 15 kHz when frequency multiplexed with the base carrier signal. The encoded terminator carrier signal typically has a voltage below about 15 volts within the prescribed frequency range and preferably has a voltage of about 0.5 volts.

When the encoded terminator carrier signal reaches the base unit 14 via the conductors 22, 24 common mode on the conductors with respect to ground, the carrier signal is received by the base pickup lines 34, 36 and carried to the low impedance input termination 218. The first and second balanced capacitors 228, 232 act as low impedances to the terminator carrier signal, carrying the signal to the base circuit common 224. The common mode terminator carrier signal is received by receiving the carrier voltage present on the ground 40 through the capacitor 274 into the carrier signal receiver 276 which is referenced to the base circuit common 224. The carrier signal receiver 276 feeds the encoded terminator carrier signal to the limiter 278 where the amplitude of the terminator carrier signal is limited thereby and then to the decoder 280 where the encoded information on the terminator carrier signal is read. The decoded information, which comprises the values of the voltage magnitude for the induced signal measured at the terminator unit 16, is sent from the decoder 280 to the microcontroller 216 for processing. The microcontroller 216 directs the reencoding of this information onto the base carrier signal so that the locator unit 12 receives encoded values of the voltage magnitude measured at both the base unit 14 and terminator unit 16 with receipt of the base carrier signal.

When the locator unit 12 is positioned at a locator point 32 between the base point 26 and the fault 20, the voltage magnitude measured at the base unit 14 is always greater or equal to that measured at the terminator unit 16. However, when the locator unit is past the fault 20, such that the locator point 32 is between the terminator point 28 and the fault 20, no voltage magnitude is detectable at the base unit 14 while a voltage magnitude is measured at the terminator unit 16. Accordingly, if the operator observes a drop in the base carrier signal at the locator unit 12, the terminator carrier signal is checked. If the terminator carrier signal is greater than the base carrier signal, the drop in the base unit signal at the locator unit 12 is confirmed to be caused by location of the fault 20. If the terminator carrier signal is less than or equal to the base carrier signal, however, the drop in the base carrier signal is attributable to causes other than location of the fault, such as a change in depth, size, gauge, or paired line location of a buried paired cable.

An alternative embodiment of a fault locating device and method of operation to that disclosed above is also provided. The alternative embodiment is substantially the same as the fault locating device 10 of Figures 1-4 except for omission of the terminator unit 16 and its corresponding function of confirming the cause of a signal drop at the base unit 14. Construction and operation of a fault locating device 10 absent a terminator unit 16 is readily apparent to the skilled artisan with reference to the disclosure provided herein. In general, inclusion or omission of the terminator unit 16 from the fault locating device 10 is entirely optional. However, inclusion of the terminator unit 16 with the fault locating device 10 is preferred for buried paired cable applications to differentiate depth changes from faults and to provide a stronger carrier signal at a distance form the paired cable. The terminator unit 16 is typically omitted from the fault locating device 10 for accessible paired cable applications.

In an alternate method of operation employing the above-described embodiment of the fault locating device, a cable shield break is located in a cable having at least one conductor surrounded by a shield. This alternate method of operation employs a combination of magnetic and capacitive carrier signal pickups. Magnetic carrier signal pickup is initially used to identify a segment of the cable containing the shield break. A segment of cable is defined for purposes of the present method as a length of cable having a ground point at each end. After the segment of cable containing the shield break is identified by means of magnetic pickup, the shield break is precisely located within the identified segment by means of capacitive pickup. Capacitive and magnetic carrier signal pickup require proper grounding of the cable segment at both ends thereof. Proper grounding includes positioning a base unit at the base point of the segment to ground the conductor of the cable segment to the cable shield thereat. Proper grounding further includes either placing a terminator unit at the terminator point of the segment to ground the conductor of the cable segment to the cable shield or, alternatively, by physically grounding the conductor of the cable segment to the cable shield at the terminator point in the absence of a terminator unit.

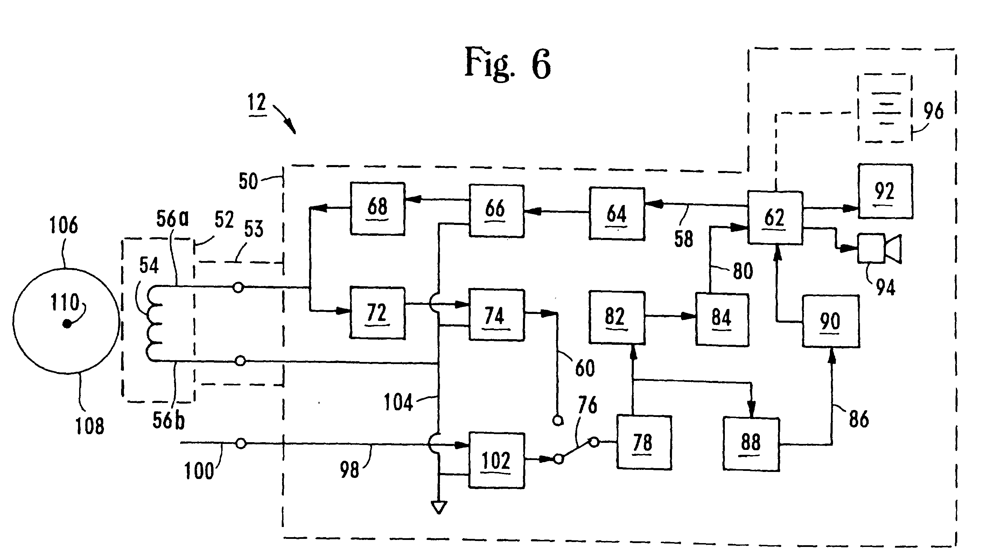

Referring specifically to Figure 6, the present method of locating a shield break in a segment of a cable 106 (shown in cross-section) is described in greater detail hereafter. The cable 106 has a shield 108 and at least one continuous concentric wire 110 enclosed thereby as a conductor, it being understood that additional continuous wires may also be present within the shield 108 to provide multiple conductors. The method is performed by initially positioning the switch 76 in the locator unit 12 to connect the carrier signal processing circuit 60 with the carrier signal receiver 78 as shown in Figure 2. The conductor 110 is grounded to the cable shield 108 at both ends of the segment and a base carrier signal is sent by the base unit along the conductor 110 of the cable 106 with reference to the cable shield 108 so that the base carrier signal on the conductor 110 is grounded to the shield 108. The base carrier signal is generated and transmitted in a manner similar to that described above with respect to Figure 3, although no synchronization information nor information with respect to the characteristics of an induced signal need be encoded on the base carrier signal. The base carrier signal is received magnetically by the coil 54 of the locator unit 12 and a base carrier signal indicator, such as voltage on the shield 108, is monitored as the locator unit 12 is moved along the length of the cable 106. Because the carrier signal will produce a relatively larger radiated magnetic field in a segment of cable having an open or improperly bonded cable shield, the base carrier signal voltage monitored at the locator unit 12 is at a maximum value when the locator unit 12 is adjacent to a segment of the cable 106 containing the shield break.

Once the segment of the cable 106 containing the shield break is identified in this manner using the speaker 94 and/or display 92 to communicate with the operator, the switch 76 is repositioned to connect the capacitive ground reference circuit 98 with the carrier signal receiver 78 as shown in Figure 6. The probe 52 is placed in contact with the cable 106, capacitively coupling the coil 54 to the shield 108. This configuration enables the coil 54 to function as a capacitor, receiving the base carrier signal directly off of the shield 108 capacitively as the locator unit 12 is moved along the length of the identified segment of the cable 106. The coil 54 sends the base carrier signal from the shield 108 to the locator circuit common 104 where the base carrier signal appears between the locator circuit common 104 and the capacitive ground reference 100. The base carrier signal is amplified by the capacitive signal preamplifier 102 and sent to the magnitude preamplifier 88 for evaluation in the same as manner described above with respect to resistance fault location, thereby enabling precise location of the shield break within the identified segment of the cable 106.

While the forgoing preferred embodiments of the invention have been described and shown, it is understood that alternatives and modifications, such as those suggested and others, may be made thereto and fall within the scope of the invention. For example, the embodiments of the fault locating device set forth above have been described as containing a number of discrete functionally-related structural components, each performing a specific function. It is apparent to the skilled artisan, however, that within the scope of the present invention certain of these discrete components can be combined into a single unitary structure as desired to perform the same functions ascribed to the discrete components.

## Claims

1. A device for locating a fault in a paired line comprising:
means positionable at a first point on a paired line for creating an induced signal in said paired line;
means connectable to a second point on said paired line for receiving said induced signal;
means associated with said induced signal receiving means at said second point for encoding a characteristic of said induced signal measured at said second point onto a carrier signal;
means for sending said carrier signal to said first point;
means positionable at said first point for receiving said carrier signal; and
means associated with said carrier signal receiving means for communicating an indicator of said characteristic of said induced signal to an operator, wherein said communicated indicator enables location of a fault in said paired line.

2. The device of claim 1 further comprising means for reducing noise received by said induced signal receiving means at said second point.

3. The device of claim 1 further comprising means for synchronizing operation of said induced signal creating means and said induced signal receiving means at said second point.

4. The device of claim 1 further comprising means connectable to said first and second conductors at a third point on said paired line for receiving said induced signal, wherein said first point is between said second and third points.

5. The device of claim 4 wherein said carrier signal is a first carrier signal, said device further comprising means associated with said induced signal receiving means at said third point for encoding a characteristic of said induced signal measured at said third point onto a second carrier signal.

6. The device of claim 5 wherein said first carrier signal has said characteristic of said first induced signal measured at said third point encoded thereon.

7. A device for locating a fault in a paired line comprising:
an induction coil movably positionable at a first point on a paired line;
an induced signal amplifier connectable to a second point on the paired line to receive an induced signal coupled to the paired line by said induction coil;
a detector in electrical communication with said induced signal amplifier to detect a characteristic of the induced signal measured at the second point;
an encoder in electrical communication with said detector to receive the characteristic of the induced signal measured at the second point and encode the characteristic onto a carrier signal;
a carrier signal receiver positionable at the first point to receive the carrier signal from said encoder; and
a decoder in electrical communication with said carrier signal receiver to decode the characteristic of the induced signal measured at the second point and encoded on the carrier signal.

8. The device of claim 7 further comprising means in electrical communication with said decoder for communicating an indicator of the decoded characteristic of the induced signal measured at the second point.

9. The device of claim 8 further comprising a processor in electrical communication with said decoder and said communicating means, wherein said processor is programmable to direct said communicating means in response to the decoded characteristic received from said decoder.

10. The device of claim 7 further comprising a noise nulling circuit wherein said induced signal amplifier is connected to the paired line through said noise nulling circuit.

11. The device of claim 7 further comprising an oscillator in electrical communication with said encoder to synchronize operation of said encoder with operation of said carrier signal receiver.

12. The device of claim 7 wherein said induced signal amplifier connectable to the paired line at the second point is a first induced signal amplifier and said device further comprises a second induced signal amplifier connectable to a third point on the paired line to receive an induced signal coupled to the first and second conductors by said induction coil, wherein the first point is between the second and third points.

13. The device of claim 12 wherein said encoder is a first encoder and the carrier signal is a first carrier signal, and said device further comprises a second encoder in electrical communication with said second induced signal amplifier to receive the characteristic of the induced signal measured at the third point and encode the characteristic onto a second carrier signal.

14. A method for locating a fault in a paired line comprising:
a) creating an induced signal at a first point of a paired line, wherein said paired line has a fault;
b) sending said induced signal on said paired line to a second point on said paired line wherein said fault is between said first and second points;
c) measuring a value of a characteristic of said induced signal at said second point;
d) encoding said characteristic of said induced signal measured at said second point onto a carrier signal;
e) sending said carrier signal to said first point;
f) communicating an indicator of said value of said characteristic of said induced signal measured at said second point;
g) incrementally shifting said first point and repeating steps a) through g); and
h) monitoring said indicator at said first point and locating a fault at said first point where said value measured at said second point changes abruptly.

15. The method of claim 14 further comprising reducing noise sent with said induced signal while measuring said characteristic of induced signal at said second point.

16. The method of claim 14 wherein said induced signal is inaudible.

17. The method of claim 14 wherein said indicator is a continuous tone correlated to a voltage magnitude of said induced signal.

18. The method of claim 14 further comprising synchronizing said sending of said carrier signal with said creation of said induced signal.

19. The method of claim 14 wherein said carrier signal is a first carrier signal and said method further comprises:
sending said induced signal to a third point on said paired line, wherein said first point is between said second and third points;
measuring a value of said characteristic of said induced signal at said third point;
encoding said value of said characteristic of said induced signal measured at said third point onto a second carrier signal;
sending said second carrier signal to said second point; and
encoding said value of said characteristic of said induced signal measured at said third point onto said first carrier signal.

20. The method of claim 19 further comprising verifying a location of said fault by comparing said value of said characteristic of said induced signal measured at said second point with said value of said characteristic of said induced signal measured at said third point.

21. A device for locating a break in a shield surrounding a cable comprising:
a coil movably positionable at a first point on a cable having a conductor enclosed by a shield with a break therein to selectively magnetically or capacitively receive a carrier signal from said cable;
a carrier signal transmitter connectable to a second point on the cable to send the carrier signal along the cable;
a carrier signal receiving circuit in electrical communication with said coil having a magnetic carrier signal amplifier positionable at the first point on the cable to receive the carrier signal magnetically received by said coil;
a means in selective electrical communication with said magnetic carrier signal amplifier for communicating an indicator of said magnetic carrier signal to an operator;
a capacitive ground reference circuit in selective electrical communication with said communicating means positionable at the first point on the cable to enable said communicating means to receive the carrier signal capacitively received by said coil; and
a switch having a first position providing electrical communication between said communicating means and said carrier signal receiving circuit, thereby enabling said communicating means to receive the carrier signal magnetically received by said coil from said cable, and having a second position providing electrical communication between said communicating means and said capacitive ground reference circuit, thereby enabling said communicating means to receive the carrier signal capacitively received by said coil from said cable.

22. The device of claim 21 further comprising means for grounding the conductor to the shield at the second point on the cable.

23. The device of claim 21 further comprising means for grounding the conductor to the shield at a third point on the cable wherein the first point is between the second and third points.

24. A device for locating a break in a shield surrounding a cable comprising:
a coil movably positionable at a first point on a cable having a conductor enclosed by a shield with a break therein;
a carrier signal transmitter connectable to a second point on the cable to send a carrier signal along the cable;
a carrier signal receiving circuit in electrical communication with said coil having a carrier signal amplifier positionable at the first point on the cable to receive the carrier signal from said coil;
a means in selective electrical communication with said carrier signal amplifier for communicating an indicator of said carrier signal to an operator.

25. The device of claim 24 wherein said carrier signal amplifier is a magnetic carrier signal amplifier for receiving the carrier signal as a magnetic carrier signal from said coil.

26. The device of claim 24 wherein said carrier signal amplifier is a capacitive carrier signal amplifier for receiving the carrier signal as a capacitive carrier signal from said coil.

27. The device of claim 24 further comprising a capacitive ground reference circuit in selective electrical communication with said communicating means positionable at the first point on the cable to enable said communicating means to receive the carrier signal as a capacitive carrier signal from said coil.

28. The device of claim 27 further comprising a switch having a first position providing electrical communication between said communicating means and said carrier signal receiving circuit, thereby enabling said communicating means to receive the carrier signal as a magnetical carrier signal from said coil, and having a second position providing electrical communication between said communicating means and said capacitive ground reference circuit, thereby enabling said communicating means to receive the carrier signal as a capacitive carrier signal from said coil.

29. A method for locating a break in a shield surrounding a cable comprising:
a) positioning a coil at a first point on a cable having a conductor enclosed by a shield with a break therein;
b) sending a carrier signal from a second point on said cable to said first point;
c) magnetically receiving said carrier signal at said first point on said cable by means of said coil;
d) monitoring a magnetic carrier signal indicator while incrementally shifting said first point between a plurality of segments of said cable and repeating steps a) through c);
e) identifying a segment of said cable as a defective segment when said magnetic carrier signal indicator achieves a maximum value relative to other segments of said cable;
f) repeating step b) and capacitively receiving said carrier signal at said first point on said cable by means of said coil;
g) monitoring a capacitive carrier signal indicator while incrementally shifting said first point within said defective segment; and
h) locating said break when said capacitive carrier signal indicator exhibits an abrupt change in value.

30. The method of claim 29 further comprising grounding said conductor to said shield at said second point on said cable.

31. The method of claim 29 further comprising grounding said conductor to said shield at a third point on said cable wherein said first point is between said second and third points.

32. A method for locating a break in a shield surrounding a cable comprising:
a) positioning a coil at a first point on a cable having a conductor enclosed by a shield with a break therein;
b) sending a carrier signal from a second point on said cable to said first point;
c) magnetically receiving said carrier signal at said first point on said cable by means of said coil;
d) monitoring a magnetic carrier signal indicator while incrementally shifting said first point between a plurality of segments of said cable and repeating steps a) through c); and
e) identifying a segment of said cable as a defective segment when said magnetic carrier signal indicator achieves a maximum value relative to other segments of said cable.

33. The method of claim 32 further comprising grounding said conductor to said shield at said second point on said cable.

34. The method of claim 32 further comprising grounding said conductor to said shield at a third point on said cable wherein said first point is between said second and third points.

35. A method for locating a break in a shield surrounding a cable comprising:
a) positioning a coil at a first point on a cable having a conductor enclosed by a shield with a break therein;
b) sending a carrier signal from a second point on said cable to said first point;
c) capacitively receiving said carrier signal at said first point on said cable by means of said coil;
d) monitoring a capacitive carrier signal indicator while incrementally shifting said first point along said cable; and
e) locating said break when said capacitive carrier signal indicator exhibits an abrupt change in value.

36. The method of claim 35 further comprising grounding said conductor to said shield at said second point on said cable.

37. The method of claim 35 further comprising grounding said conductor to said shield at a third point on said cable wherein said first point is between said second and third points.
